# EUROPÄISCHE PATENTANMELDUNG

(11) **EP 1 347 576 A2**
(43) Veröffentlichungstag der Anmeldung: **24.09.2003**
(21) Anmeldenummer: 03005266.6
(22) Anmeldetag: 10.03.2003
(51) Int. Cl.: H03K 17/0812

(54) **Ansteuerschaltung für einen Sperrschicht-Feldeffekttransistor**

(30) Priorität: 22.03.2002 DE 10212863
(71) Anmelder: SIEMENS AKTIENGESELLSCHAFT, 80333 München (DE)
(72) Erfinder: Braun, Matthias, 63639 Flörsbachtal (DE); Weis, Benno, 91334 Hemhofen (DE)

(57) **Zusammenfassung**

Ansteuerschaltung für einen Sperrschicht-Feldeffekttransistor (T₁), der Anschlüsse für Gate (G), Drain (D) und Source (S) hat sowie einen Gate-Leckstrom und einen maximal zulässigen Gate-Strom aufweist, mit einer das Gate speisenden Stromquelle (Q), die zum Ausschalten des Sperrschicht-Feldeffekttransistors (T₁) einen Steuerstrom (I_{G}) erzeugt, der größer als der Gate-Leckstrom (I_{G}) und kleiner als der maximal zulässige Gate-Strom ist.

## Beschreibung

Die Erfindung betrifft eine Ansteuerschaltung für einen Sperrschicht-Feldeffekttransistor.

Sperrschicht-Feldeffekttransistoren (JFETs), wie Sie beispielsweise aus U. Tietze, Ch. Schenk, Halbleiter-Schaltungstechnik, 9. Auflage 1990, Seiten 83 bis 101 bekannt sind, haben die Eigenschaft, dass sie bei einer Gate-Spannung von 0 Volt leiten und mit negativer Gate-Spannung beim n-Kanal-Typ bzw. mit positiver Gate-Spannung beim p-Kanal-Typ abgeschnürt werden können. Die hierzu erforderlichen Gate-Spannungen schwanken jedoch bei unterschiedlichen Exemplaren des selben Leitungstyps in einem sehr weiten Bereich.

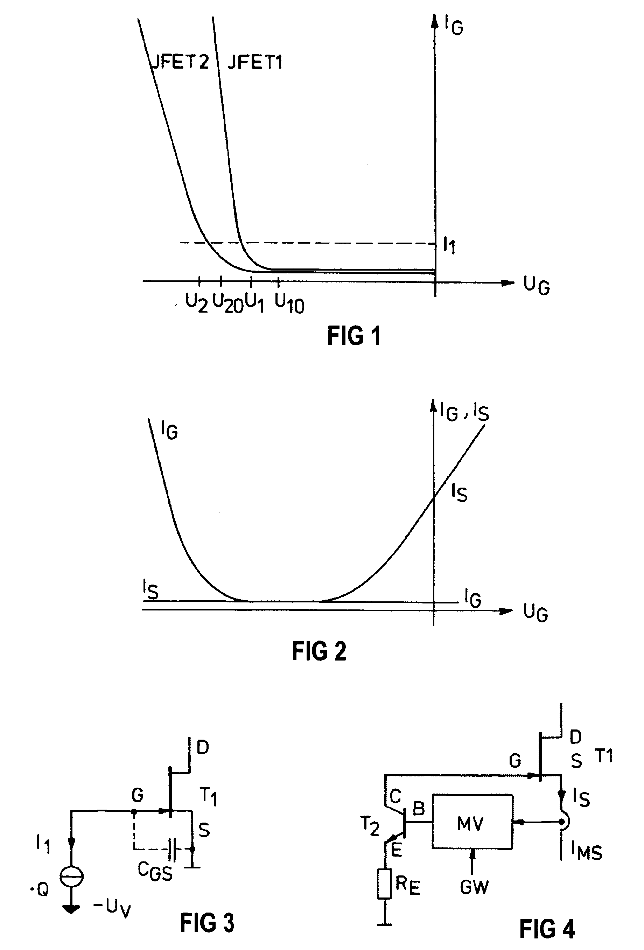

In FIG 1 sind zwei typische Kennlinien der Gate-Leckströme I_{G} zwei verschiedener Sperrschicht-Feldeffekttransistoren dargestellt. Wie leicht zu erkennen ist, steigt der Leckstrom I_{G} eines Sperrschicht-Feldeffekttransistors JFET1 ab einer Spannung U₁ stark an. Das bedeutet, dass am Gate des JFET1 die Spannung U₁ nur geringfügig überschritten werden darf, da ansonsten am Gate eine zu hohe Verlustleistung auftritt. Damit aber der Sperrschicht-Feldeffekttransistor sicher sperrt, muss die Gate-Spannung jedoch sicher eine Spannung U₁₀ überschreiten, damit der Sperrschicht-Feldeffekttransistor JFET 1 sicher sperrt. Dabei ist die Gate-Spannung U₁₀ nur wenig, typischerweise 5 bis 10 V, unterhalb der Gate-Spannung U₁. Würde man eine Gate-Spannung als feste Vorgabe für alle Sperrschicht-Feldeffekttransistoren eines Umrichters wählen, die geringfügig größer als die Gate-Spannung U₁ₒ und kleiner als U₁ ist, so würde ein Sperrschicht-Feldeffekttransistor JFET2 nicht sperren können, da die Gate-Spannung beispielsweise unter seiner minimal erforderlichen Gate-Spannung U₂₀ liegt. Würde jedoch andernfalls eine Gate-Spannung gewählt, die größer als die minimal erforderliche Gate-Spannung U₂₀ des Feldeffekttransistors JFET2 ist, so würde der Sperrschicht-Feldeffekttransistor JFET1 bei einer derartigen Ansteuerung zerstört, da sein Gate-Strom in unzulässiger Weise ansteigen würde.

Bei in Umrichtern verwendeten Sperrschicht-Feldeffekttransistoren können die Abschnürspannungen beispielsweise in einen Bereich zwischen -17 V und -57 V schwanken. Bei herkömmlichen Ansteuerschaltungen, die die Gate-Source-Spannungen wahlweise auf 0 V zum Einschalten und eine negative Spannung zum Ausschalten legen, muss die Ansteuerspannung individuell auf den jeweiligen Sperrschicht-Feldeffekttransistor eingestellt werden. Dies bedeutet einen erheblichen Aufwand, der insbesondere bei Serienfertigung nicht akzeptabel ist.

Aufgabe der Erfindung ist es daher, eine Ansteuerschaltung für einen Sperrschicht-Feldeffekttransistor anzugeben, die diese Nachteile nicht aufweist.

Die Aufgabe wird gelöst durch eine Ansteuerschaltung gemäß Patentanspruch 1. Ausgestaltungen und Weiterbildungen des Erfindungsgedankens sind Gegenstand von Unteransprüchen.

Im einzelnen umfasst eine erfindungsgemäße Ansteuerschaltung für einen Sperrschicht-Feldeffekttransistor, der Anschlüsse für Gate, Drain und Source hat, sowie einen Gate-Leckstrom und einen maximal zulässigen Gate-Strom aufweist, eine das Gate speisende Stromquelle, die zum Ausschalten des Sperrschicht-Feldeffekttransistors einen Steuerstrom erzeugt, der größer ist als der Gate-Leckstrom und kleiner als der maximal zulässige Gate-Strom.

Die Erfindung beruht demnach darauf, dass nicht die Gate-Spannungen, sondern der Gate(-Leck)-Strom für das Ausschalten des Sperrschicht-Feldeffekttransistors eingestellt wird. Dabei wird davon ausgegangen, dass das Gate des Sperrschicht-Feldeffekttransistors eine Strom-Spannungs-Kennlinie aufweist, bei der der Gate-Leckstrom mit steigender Gate-Spannung monoton zunimmt.

Die Gate-Spannung wird dabei so eingestellt, dass über das Gate des Sperrschicht-Feldeffekttransistors ein bestimmter Gate-Leckstrom fließt. Dieser wird so gewählt, dass der Sperrschicht-Feldeffekttransistor sicher abgeschnürt wird, ohne jedoch eine thermische Gefährdung des Gates zu verursachen. Im Hinblick auf die in FIG 1 gezeigten Beispiele für Sperrschicht-Feldeffekttransistoren JFET 1 und JFET 2 würde beispielsweise ein Strom I₁ gewählt werden, der etwas über dem Plateaubereich der beiden Sperrschicht-Feldeffekttransistoren JFET 1 und JFET 2 liegt. Die erforderlichen Gate-Spannungen für die Sperrschicht-Feldeffekttransistoren JFET 1 und JFET 2 stellen sich dabei dementsprechend ein.

Bevorzugt wird jedoch der Steuerstrom geregelt, wozu die Ansteuerschaltung eine die Stromquelle steuernde Regeleinrichtung aufweist.

Bei einer Ausgestaltung einer Regeleinrichtung ist eine Messeinrichtung zum Bestimmen des Source-Stromes und eine Vergleichseinrichtung zum Vergleichen des Source-Stromes mit einem Grenzwert vorgesehen, wobei der Steuerstrom so lange erhöht wird, bis der Source-Strom den Grenzwert unterschreitet. In FIG 2 sind Gate-Strom I_{G} und Source-Strom I_{S} als Funktion der Gate-Spannung U_{G} dargestellt. Wie bereits in FIG 1 dargelegt, steigt der Gate-Strom I_{G} mit wachsender Gate-Spannung U_{G} an. Der Source-Strom I_{S} nimmt jedoch mit steigender Gate-Spannung U_{G} ab, da der Kanal des Sperrschicht-Feldeffekttransistors immer stärker abgeschnürt wird, bis bei sehr hoher Gate-Spannung U_{G} der gesamte Drain-Strom I_{D} über das Gate fließt.

Alternativ dazu kann die Regeleinrichtung eine Messeinrichtung zum Bestimmen des Source-Stromes und ein Proportional-Regelglied aufweisen, wobei der Steuerstrom auf ein bestimmtes Verhältnis zum Source-Strom eingestellt wird.

Bei einer dritten Alternative wertet die Messeinrichtung den Gate-Strom und den Source-Strom getrennt aus, wobei ein Minimum-Detektor zum Bestimmen des Minimums des Drain-Stromes die Minima von Gate-Strom und Source-Strom jeweils einzeln bestimmt und bei Vorliegen zweier Minima ein Minimum des Drain-Stromes erkennt. Bei dieser Ausgestaltung wird angestrebt, dass die statischen Sperrverluste minimal werden. Dies wird dadurch erreicht, dass der Drain-Strom des Sperrschicht-Feldeffekttransistors minimal wird. Der Drain-Strom ist die Summe aus Gate-Strom und Source-Strom. Die Summe aus Gate-Strom I_{G} und Source-Strom I_{S} besitzt nach FIG 2 ein Minimum, auf welches die Gate-Spannung U_{G} in Weiterbildung der Erfindung geregelt wird. Die Eingangsgrößen für diese Regelung basieren entweder auf einer Messung des Drain-Stromes oder auf einer Messung von Gate-Strom und Source-Strom.

Die bisher beschriebenen Maßnahmen sind im wesentlichen bezüglich des statischen Sperrverhaltens des Sperrschicht-Feldeffekttransistors anwendbar. Beim Durchschalten des Sperrschicht-Feldeffekttransistors müssen jedoch höhere Gate-Ströme zugelassen werden, um eine hohe Schaltgeschwindigkeit zu erreichen. Aus diesem Grund wird für die Zeitdauer der Einschaltvorgänge die Ansteuerschaltung derart betrieben, dass der Steuerstrom und insbesondere dessen Regelung abgeschaltet wird. Das Einschalten wird dann beispielsweise mit bekannten Verfahren wie z.B. Umschalten auf einen spannungsgesteuerten Betrieb realisiert.

Schließlich wird bevorzugt der Sperrschicht-Feldeffekttransistor in Silizium-Carbid-Technologie realisiert.

Die Erfindung wird nachfolgend anhand der in den Figuren der Zeichnung dargestellten Ausführungsbeispiele näher erläutert. Es zeigen:
- FIG 1: den Verlauf des Gate-Stromes in Abhängig von der Gate-Spannung für zwei Exemplare von Sperrschicht-Feldeffekttransistoren des gleichen Typs,
- FIG 2: den Verlauf des Gate-Stromes und des Source-Stromes über der Gate-Spannung eines Sperrschicht-Feldeffekttransistors,
- FIG 3: ein erstes Ausführungsbeispiel einer erfindungsgemäßen Ansteuerschaltung,
- FIG 4: ein zweites Ausführungsbeispiel einer erfindungsgemäßen Ansteuerschaltung,
- FIG 5: ein drittes Ausführungsbeispiel einer erfindungsgemäßen Ansteuerschaltung und
- FIG 6: die Anwendung einer erfindungsgemäßen Ansteuerschaltung bei einer Wechselrichteranordnung.

Bei dem in FIG 3 gezeigten Ausführungsbeispiel ist ein Sperrschicht-Feldeffekttransistor T₁ vorgesehen, der Anschlüsse für Drain D, Source S und Gate G aufweist. Zwischen Gate und Source bildet sich dabei eine parasitäre Gate-Source-Kapazität C_{GS} aus. Das Gate wird dabei über eine Stromquelle Q von einem negativen Versorgungspotential -U_{V} aus versorgt. Der durch die Stromquelle Q eingeprägte Strom entspricht dabei dem Strom I₁ aus FIG 1. Das negative Versorgungspotential -U_{V} ergibt sich daraus, dass der Sperrschicht-Feldeffekttransistor vom n-Kanal-Typ ist.

Das Ausführungsbeispiel nach FIG 4 ist gegenüber dem in FIG 3 gezeigten Ausführungsbeispiel dahingehend abgeändert, dass anstelle der Stromquelle Q die gesteuerte Strecke eines Bipolartransistors T₂, der eine Basis, einen Kollektor und einen Emitter aufweist, vorgesehen ist, wobei in die Emitterleitung des Transistors T₂ ein Emitterwiderstand R_{E} geschaltet ist. Beim vorliegenden Ausführungsbeispiel handelt es sich beim Transistor T₂ um einen Bipolartransistor vom npn-Typ. Der Kollektor des Bipolartransistors T₂ ist dabei mit dem Gate des Sperrschicht-Feldeffekttransistors T1 verbunden, während der Emitter des Bipolartransistors T₂ über den besagten Emitterwiderstand R_{E} an das negative Versorgungspotential -U_{V} angeschlossen ist. Die Basis des Bipolartransistors T₂ ist mit dem Ausgang eines Messverstärkers MV verschaltet, dessen Eingang durch eine Strommesseinrichtung IN angesteuert wird, die den in der Sourceleitung des Sperrschicht-Feldeffekttransistors T1 fließenden Strom I_{S} misst. In diesem Fall ist der Gate-Strom I_{G} dem Source-Strom I_{S} proportional. Ein hoher Source-Strom I_{S} führt somit zu einem erhöhten Gate-Strom I_{G} und somit zu einem verstärkten Abschnüren. Als Alternative kann der Messverstärker MV mit sehr hoher Verstärkung betrieben werden, wobei er dann als Komparator fungiert, wobei der Gate-Strom I_{G} so lange erhöht wird, bis der Source-Strom einen Grenzwert GW unterschreitet. Der Grenzwert GW kann dabei extern vorgegebenen werden oder im Messverstärker MV generiert werden.

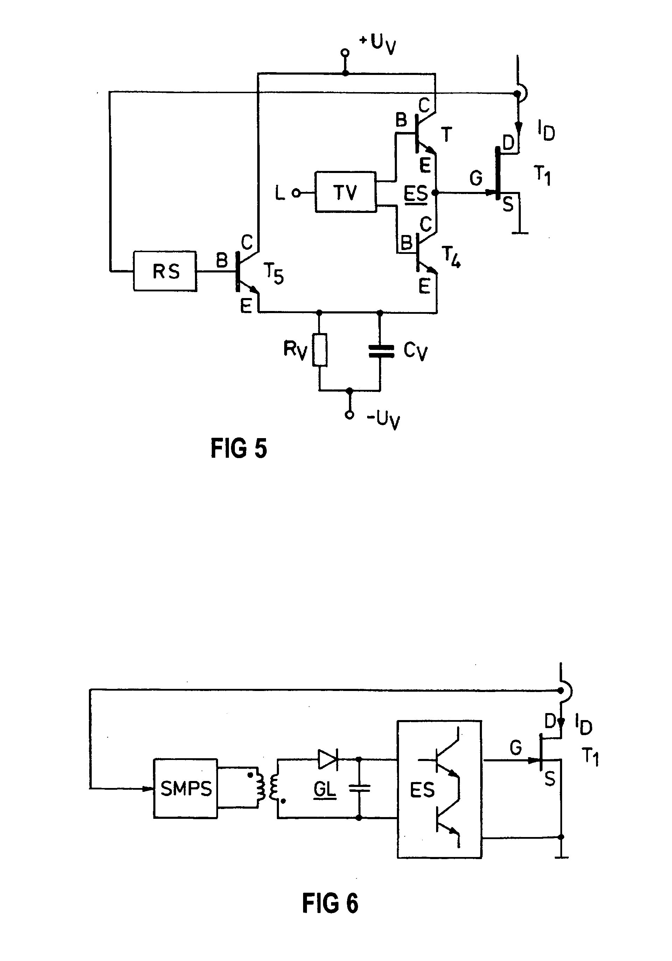

Bei dem in FIG 5 gezeigten Ausführungsbeispiel wird der Sperrschicht-Feldeffekttransistor T₁ an seinem Gate-Anschluss mittels einer Gegentaktendstufe ES angesteuert. Die Gegentaktendstufe ES besteht aus zwei Bipolartransistoren T3 und T4 vom npn-Typ von denen die gesteuerte Strecke (Emitter-Kollektor-Strecke) des einen Bipolartransistors T₃ zwischen das Gate G des Sperrschicht-Feldeffekttransistors T₁ und ein positives Versorgungspotential +U_{V} geschaltet ist, während die gesteuerte Strecke (Emitter-Kollektor-Strecke) des anderen Bipolartransistors T₄ zwischen das Gate des Sperrschicht-Feldeffekttransistors T₁ und einen Knotenpunkt geschaltet ist, an dem zudem der Emitter eines Bipolartransistors T vom npn-Typ, ein Anschluss eines Widerstandes R_{V} und ein Anschluss eines Kondensators C_{V} angeschlossen sind. Die Basen der Bipolartransistoren T₃ und T₄ werden dabei über einen Treiberverstärker TV durch ein Schaltsignal L geschaltet. Die Spannung über der Gegentaktendstufe ES wird dabei mittels des Bipolartransistors T₅ geregelt. Die Spannung zwischen der Basis des Bipolartransistors T₅ und dem negativen Versorgungspotential -U_{V}, nämlich die Regelspannung Uᵢₙ wird ständig um einen kleinen Wert mittels einer Regelschaltung RS verändert. Dabei wird der Drain-Strom I_{D} gemessen und die Regelspannung Uᵢₙ in der Richtung verändert, in der der Drain-Strom I_{D} kleiner wird. Auf diese Art und Weise kann das Minimum des Drain-Stromes I_{D} eingestellt werden. Statt einer Stromregelung kann also auch die Versorgungsspannung nachgeführt werden, wie dies in FIG 5 dargestellt ist.

Die in FIG 5 gezeigte Maßnahme kann gemäß FIG 6 noch weiter verbessert werden, indem die durch negatives und positives Versorgungspotential +U_{V} und -U_{V} definierte Versorgungsspannung an den minimalen Drain-Strom I_{D} dadurch angepasst wird, dass das versorgende (Schalt-)Netzteil die gewünschte Versorgungsspannung einstellt. Dadurch können die Ansteuerverluste minimiert werden, da der Parallelregler (Bipolartransistor T₅) aus FIG 5 entfällt. Stattdessen erfolgt die Speisung der Endstufe IS direkt aus einem Gleichrichter GL der mittels eines Übertragers Ü zur Potentialtrennung durch einen Schaltregler SMPS in Abhängigkeit vom Drain-Strom I_{D} gesteuert wird.

Bei sämtlichen hier gezeigten Beispielen handelt es sich bei dem Sperrschicht-Feldeffekttransistor T₁ um einen Silizium-Carbid-Transistor.

Schließlich können auch zwei Aussteuerschaltungen zum Einund Ausschalten einer Einrichtung für den Steuerstrom parallel geschaltet werden.

## Patentansprüche

1. Ansteuerschaltung für einen Sperrschicht-Feldeffekttransistor (T₁), der Anschlüsse für Gate (G), Drain (D) und Source (S) hat sowie einen Gate-Leckstrom und einen maximal zulässigen Gate-Strom aufweist, mit einer das Gate speisenden Stromquelle (Q), die zum Ausschalten des Sperrschicht-Feldeffekttransistors (T₁) einen Steuerstrom (I_{G}) erzeugt, der größer als der Gate-Leckstrom (I_{G}) und kleiner als der maximal zulässige Gate-Strom ist.

2. Ansteuerschaltung nach Anspruch 1, bei der eine Regeleinrichtung (MV, T₂; RS, T₅) zum Regeln des Steuerstroms (I_{G}) aufweist.

3. Ansteuerschaltung nach Anspruch 2, bei der die Regeleinrichtung eine Messeinrichtung zum Bestimmen des Source-Stromes (I_{S}) und eine Vergleichseinrichtung zum Vergleichen des Source-Stromes mit einem Grenzwert aufweist, wobei der Steuerstrom (I_{G}) solange erhöht wird, bis der Source-Strom (I_{S}) den Grenzwert (GW) unterschreitet.

4. Ansteuerschaltung nach Anspruch 2, bei der die Regeleinrichtung eine Messeinrichtung zum Bestimmen des Source-Stromes (I_{S}) und ein Proportional-Regelglied (M_{V}) aufweist, wobei der Steuerstrom (I_{G}) auf ein bestimmtes Verhältnis zum Source-Strom eingestellt wird.

5. Ansteuerschaltung nach Anspruch 2, bei der bei der die Regeleinrichtung eine Messeinrichtung zum Bestimmen des Drain-Stromes (I_{D}) und einen Minimum-Detektor (RS) aufweist, wobei der Steuerstrom (I_{G}) solange verändert wird, bis der Drain-Strom (I_{D}) ein Minimum erreicht hat.

6. Ansteuerschaltung nach Anspruch 5, bei der die Messeinrichtung zum Bestimmen des Drain-Stromes (I_{D}) den Gate-Strom (I_{G}) und den Source-Strom (I_{S}) getrennt auswertet und der Minimum-Detektor (RS) zum Bestimmen des Minimums des Drain-Stromes die Minima von Gate-Strom (I_{G}) und Source-Strom (IS) jeweils einzeln bestimmt.

7. Ansteuerschaltung nach einem der vorherigen Ansprüche, bei der für die Zeitdauer des Einschaltens des Sperrschicht-Feldeffekttransistors (T₁) der Steuerstrom abgeschaltet ist.

8. Ansteuerschaltung nach Anspruch 7, bei der für die Zeitdauer des Einschaltens des Sperrschicht-Feldeffekttransistors (T₁) eine Steuerspannung erzeugt wird.

9. Ansteuerschaltung nach einem der vorherigen Ansprüche, bei der der Sperrschicht-Feldeffekttransistor (T₁) ein SiC-Transistor ist.
